# DEMANDE DE BREVET EUROPEEN

(11) **EP 0 923 143 A1**
(43) Date de publication de la demande: **16.06.1999**
(21) Numéro de dépôt: 98402808.4
(22) Date de dépôt: 13.11.1998
(51) Int. Cl.: H01L 39/14, H01L 39/24

(54) **Procédé de fabrication d'un brin supraconducteur multifilamentaire, stable et à pertes réduites**

(30) Priorité: 13.11.1997 FR 9714222
(71) Demandeur: GEC ALSTHOM ELECTROMECANIQUE SA, 75116 Paris (FR)
(72) Inventeur: Bruzek, Christian Eric, 90000 Belfort (FR); Mocaer, Philippe, GEC Alsthom Electromecanique SA, 90018 Belfort Cedex (FR)
(74) Mandataire: Gosse, Michel

(57) **Abrégé**

L'invention a pour objet un procédé de fabrication d'un brin supraconducteur multifilamentaire, stable et à pertes réduites, caractérisé en ce qu'il comprend la réalisation d'une billette par mise en oeuvre de la technique de mono-empilement ou Single Stacking, en interposant des tiges de matrice conductrice et/ou des tiges de matrice résistive dans la zone filamentaire supraconductrice de ladite billette, de manière à former des canaux de matrice entre des paquets de filaments supraconducteurs. De préférence, les tiges ont une section polygonale, de préférence carrée ou rectangulaire, de préférence encore hexagonale.

## Description

L'invention concerne la fabrication d'un brin supraconducteur constitué par un grand nombre de filaments.

Plus précisément, elle a pour objet un procédé de fabrication d'un brin supraconducteur multifilamentaire stable et à pertes réduites, lequel procédé est plus rapide et plus économique que les procédés de l'art antérieur.

Lorsque l'on fabrique un brin supraconducteur, on doit résoudre, entre autres, deux problèmes, à savoir l'amélioration de la stabilité du supraconducteur, d'une part et la diminution des pertes, d'autre part.

Selon les utilisations envisagées, on favorise plutôt l'une ou plutôt l'autre de ces exigences en faisant varier la composition de la matrice.

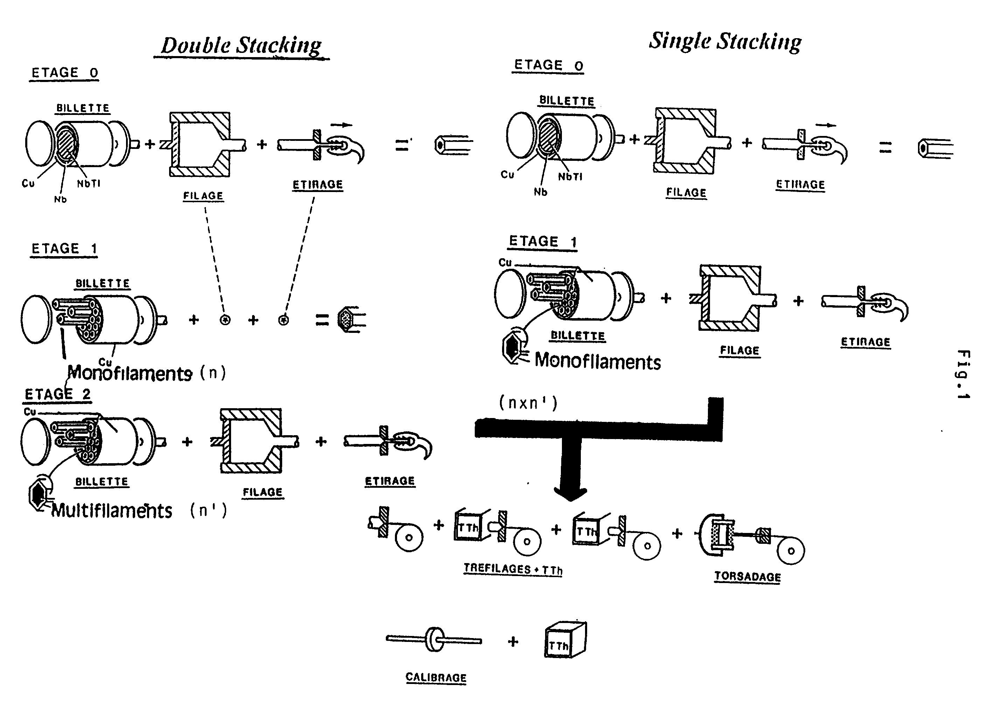

Pour fabriquer un brin supraconducteur multifilamentaire, il existe actuellement deux techniques qui présentent chacune des avantages et des inconvénients qui leur sont propres. Ces techniques sont décrites brièvement ci-après, en référence à la figure 1 des dessins annexés.

La technique de "double empilement" connue sous le nom de "Double Stacking" nécessite trois étapes :
- **étage 0** : fabrication de tiges monofilamentaires par filage et étirage de billettes contenant un alliage supraconducteur dans une matrice (dans l'exemple représenté : alliage de NbTi ; matrice de Cu) ;
- **étage 1** : assemblage d'un grand nombre de tiges monofilamentaires (en général inférieur à 1000), dans un tube de matrice (Cu dans l'exemple présenté);
- **étage 2** : assemblage d'un grand nombre de tiges multifilamentaires (en général inférieur à 1000), dans un tube de matrice (Cu dans l'exemple présenté).

Le brin est ensuite soumis à des processus usuels de tréfilages, traitements thermiques, torsadage et calibrage.

Cette technique permet d'obtenir des brins avec des canaux de matrice à l'intérieur de la zone filamentaire. Ces canaux sont les tubes de matrice dans lesquels les tiges monofilamentaires sont assemblées à l'étage 1. La présence de ces canaux augmente la stabilité thermique du fil et permet de contrôler le niveau des pertes par couplage dans la zone filamentaire. Toutefois, cette technique est coûteuse et peu productive.

La technique de "mono-empilement" connue sous le nom de "Single Stacking" ne nécessite que deux étapes :
- **étage 0** : fabrication de tiges monofilamentaires par filage et étirage de billettes contenant un alliage supraconducteur dans une matrice, comme dans la technique précédente ;
- **étage 1** : assemblage de tiges monofilamentaires dont le nombre est éqivalent au nombre de filaments de l'étage 2 cité ci-dessus, dans un tube de matrice (Cu dans l'exemple proposé).

Le brin est ensuite soumis à des processus usuels, comme dans la technique précédente.

La technique de mono-empilement est moins coûteuse et plus productive que la technique de double empilement mais l'absence de canaux de matrice entre des paquets de filaments limite la stabilité thermique du conducteur ainsi que les possibilités de contrôle des pertes par couplage, comme obtenu selon la technique de double empilement.

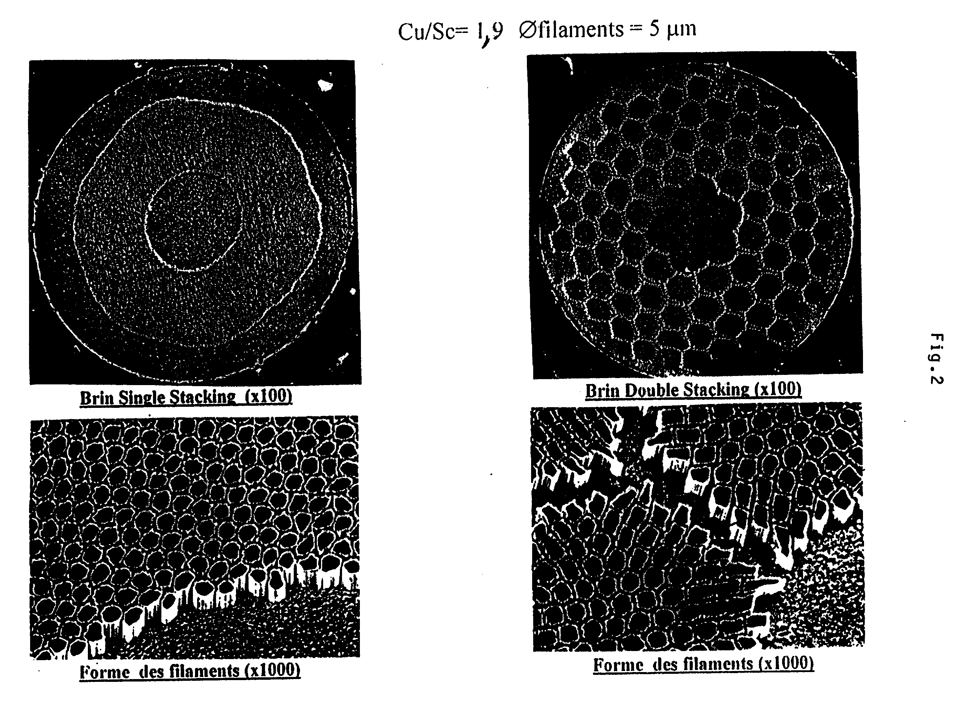

La figure 2 des dessins annexés représente les coupes transversales d'un brin "Single Stacking" et d'un brin "Double Stacking", chacun aux grossissements x100 et x1000. Ces brins sont destinés à être utilisés dans la fabrication de la couche interne conductrice d'un aimant dipolaire d'un accélérateur de particules. Dans ces brins, le rapport matrice (Cu)/supraconducteur (Sc) est de 1,9.

Cette figure permet de comparer les deux techniques décrites ci-dessus. Elle montre en particulier (grossissements x1000) l'existence de canaux de Cu dans le cas du "Double Stacking" et leur absence dans le cas du "Single Stacking".

Le but de l'invention est de mettre au point un procédé de fabrication d'un brin supraconducteur multifilamentaire ayant une stabilité thermique accrue et permettant de contrôler le niveau des pertes par couplage, par rapport à un brin fabriqué selon la technique de "Single Stacking", en diminuant les coûts et en augmentant la productivité par rapport à la technique de "Double Stacking".

Ce but est atteint, selon l'invention, grâce à un procédé de type "Single Stacking" qui permet d'obtenir un brin ayant une vue en coupe similaire à celle d'un brin obtenu selon la technique de "Double Stacking".

Plus précisément, l'invention a pour objet un procédé de fabrication d'un brin supraconducteur multifilamentaire, stable et à pertes réduites, caractérisé en ce qu'il comprend la réalisation d'une billette par mise en oeuvre de la technique de mono-empilement ou Single Stacking, en interposant des tiges de matrice conductrice et/ou des tiges de matrice résistive dans la zone filamentaire supraconductrice de ladite billette, de manière à former des canaux de matrice entre des paquets de filaments supraconducteurs.

La zone filamentaire supraconductrice est essentiellement constituée de tiges à base d'au moins un alliage supraconducteur, notamment un alliage de niobium (Nb) tel que, par exemple, NbTi et Nb₃Sn.

Les tiges de matrice conductrice sont avantageusement en cuivre et les tiges de matrice résistive sont avantageusement en cupronickel.

Ces tiges peuvent avoir des sections de formes variées. Elles ont toutefois de préférence une section polygonale, notamment carrée, rectangulaire ou mieux hexagonale.

L'assemblage des tiges pour former la billette est avantageusement effectué selon le procédé décrit dans le brevet FR 91 00795 (2 672 150) ayant pour titre : "Procédé d'assemblage de billettes composites pour la fabrication de brins supraconducteurs multifilamentaires".

La nature, le nombre et la position des tiges interposées peuvent varier considérablement selon les applications envisagées et les caractéristiques recherchées.

Le procédé selon l'invention offre ainsi, en particulier, la possibilité de contrôler très finement les résistances électrique et thermique du brin supraconducteur multifilamentaire ainsi fabriqué.

### EXEMPLE

En utilisant le procédé selon l'invention avec le procédé décrit dans le brevet FR 91 00795 et en utilisant des tiges hexagonales qui permettent d'obtenir un remplissage optimal, on fabrique un brin supraconducteur pour les accélérateurs de particules.

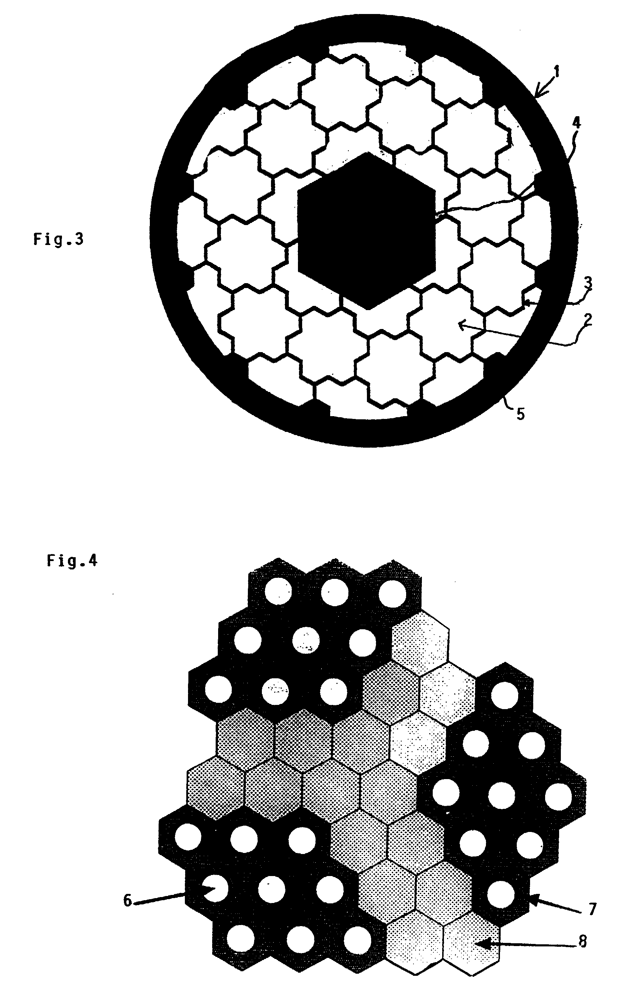

La figure 3 des dessins annexés représente schématiquement une vue en coupe de ce brin 1 qui comprend des zones 2 composées de filaments supraconducteurs entourés de cuivre ou d'un alliage cuivreux, des paquets de ces filaments étant eux-mêmes entourés d'une paroi interne 3 en cuivre ou en alliage cuivreux, ainsi qu'une tige centrale 4 et une gaine extérieure 5 l'une et l'autre en cuivre ou en alliage cuivreux.

La figure 4 des dessins annexés représente schématiquement un détail des environs d'une partie de la paroi interne du brin de la figure 3. On y voit des filaments supraconducteurs 6 noyés dans une matrice de cuivre ou d'alliage cuivreux 7, 8.

## Revendications

1. Procédé de fabrication d'un brin supraconducteur multifilamentaire, stable et à pertes réduites, caractérisé en ce qu'il comprend la réalisation d'une billette par mise en oeuvre de la technique de mono-empilement ou Single Stracking, en interposant des tiges de matrice conductrice et/ou des tiges de matrice résistive dans la zone filamentaire supraconductrice de ladite billette, de manière que les tiges de matrice entourent des paquets de filaments supraconducteurs pour former des canaux de matrice entre ces paquets de filaments supraconducteurs.

2. Procédé selon la revendication 1, caractérisé en ce que la zone filamentaire supraconductrice est essentiellement constituée de tiges à base d'au moins un alliage de niobium.

3. Procédé selon la revendication 2, caractérisé en ce que l'alliage de niobium est NbTi ou Nb₃Sn.

4. Procédé selon l'une quelconque des revendications 1 à, caractérisé en ce que les tiges de matrice conductrice sont en cuivre.

5. Procédé selon l'une quelconque des revendications 1 à 4, caractérisé en ce que les tiges de matrice résistive sont en cupronickel.

6. Procédé selon l'une quelconque des revendications 1 à 5, caractérisé en ce que les tiges ont une section polygonale, de préférence carrée ou rectangulaire, de préférence encore hexagonale.
